# EUROPEAN PATENT SPECIFICATION

(11) **EP 4 283 804 B1**
(45) Date of publication and mention of the grant of the patent: **28.01.2026**
(21) Application number: 23174040.8
(22) Date of filing: 17.05.2023
(51) Int. Cl.: H01S 5/185, H01S 5/11, H01S 5/042, H01S 5/20, H01S 5/343, H01S 5/00

(54) **METHOD OF MANUFACTURING A PHOTONIC CRYSTAL SURFACE-EMITTING LASER ELEMENT**
VERFAHREN ZUR HERSTELLUNG EINES OBERFLÄCHENEMITTIERENDEN LASERELEMENTS MIT PHOTONISCHEM KRISTALL
PROCÉDÉ DE FABRICATION D'UN ÉLÉMENT LASER À CRISTAL PHOTONIQUE À ÉMISSION PAR LA SURFACE

(30) Priority: 25.05.2022 JP 2022085274
(43) Date of publication of application: 29.11.2023
(73) Proprietor: Kyoto University, Kyoto-shi, Kyoto 606-8501 (JP); Stanley Electric Co., Ltd., Meguro-ku Tokyo 153-8636 (JP)
(72) Inventor: NODA, Susumu, Kyoto 606-8501 (JP); EMOTO, Kei, Tokyo 153-8636 (JP); KOIZUMI, Tomoaki, Tokyo 153-8636 (JP); KOTANI, Hiroshi, Tokyo 153-8636 (JP)
(74) Representative: Wimmer, Hubert

(56) References cited:
- WO-A1-2021/186965
- US-A1- 2009 279 579
- DE ZOYSA MENAKA ET AL: "Light Detection Functionality of Photonic-Crystal Lasers", IEEE JOURNAL OF QUANTUM ELECTRONICS, IEEE, USA, vol. 57, no. 4, 21 June 2021 (2021-06-21), pages 1 - 8, XP011865093, ISSN: 0018-9197, [retrieved on 20210702], DOI: 10.1109/JQE.2021.3091153
- SAKAGUCHI T ET AL: "Surface-emitting photonic-crystal laser with 35W peak power", LASERS AND ELECTRO-OPTICS, 2009 AND 2009 CONFERENCE ON QUANTUM ELECTRONICS AND LASER SCIENCE CONFERENCE. CLEO/QELS 2009. CONFERENCE ON, IEEE, PISCATAWAY, NJ, USA, 2 June 2009 (2009-06-02), pages 1 - 2, XP031520526, ISBN: 978-1-55752-869-8

## Description

### BACKGROUND OF THE INVENTION

### 1. Field of the Invention

The present invention relates to a method of manufacturing a surface-emitting laser element, and particularly to a method of manufacturing a surface-emitting laser element having a photonic crystal.

### 2. Description of the Related Art

In recent years, the development of a photonic-crystal surface-emitting laser (PCSEL) using a photonic crystal (PC) has progressed.

For example, JP 2015-149403 A discloses a photonic-crystal surface-emitting laser that includes a p-side electrode that functions as a reflection surface and is capable of emitting a main beam and a sub-beam.

Yoshida, M. et al., Double-lattice photonic-crystal resonators enabling high-brightness semiconductor lasers with symmetric narrow-divergence beams. Nat. Mater. 18, 121 (2019) discloses a photonic-crystal surface-emitting laser using a semiconductor DBR as a p-side reflection structure. Hirose, K. et al. Watt-class high-power, high-beam-quality photonic-crystal lasers. Nat. Photon. 8, 406-411 (2014) discloses a high-power photonic-crystal surface-emitting laser including a p-side electrode that functions as a reflection surface.

Y. Liang et al: Phys. Rev. B vol. 84, 195119 (2011)discloses a formulation of diffracted light of a photonic-crystal surface-emitting laser, a diffracted radiation wave profile that is diffracted in a photonic crystal layer and emitted in a direction perpendicular to the photonic crystal layer, and the like.

WO 2021/186965 A discloses a surface-emitting laser element and surface-emitting laser element manufacturing method. The surface-emitting laser element comprises: a first guide layer including a photonic-crystal layer that is formed on a c surface of a group III nitride semiconductor and that has holes which are arranged with two-dimensional periodicity in a plane parallel to the layer, and an embedded layer that is formed on the photonic-crystal layer and that closes the holes; an active layer that is formed on the first guide layer; and a second guide layer that is formed on the active layer. A hole set, which includes at least a main hole and a sub hole that is smaller in size than the main hole, is disposed at each square lattice point in the plane parallel to the photonic-crystal layer. The main holes have a regular hexagonal prism shape, an elongated hexagonal prism shape, or an elliptical prism shape in which the longer axis is parallel to a <11-20> axis.

Attention is also drawn to:
US 2009/279579 A1;
DE ZOYSA MENAKA ET AL, "Light Detection Functionality of Photonic-Crystal Lasers", IEEE JOURNAL OF QUANTUM ELECTRONICS, IEEE, USA, vol. 57, no. 4, doi:10.1109/JQE.2021.3091153, ISSN 0018-9197, June 21, 2021, pages 1 - 8; and
SAKAGUCHI T ET AL, "Surface-emitting photonic-crystal laser with 35W peak power", LASERS AND ELECTRO-OPTICS, 2009 AND 2009 CONFERENCE ON QUANTUM ELECTRONICS AND LASER SCIENCE CONFERENCE. CLEO/QELS 2009. CONFERENCE ON, IEEE, PISCATAWAY, NJ, USA, June 2, 2009, ISBN 978-1-55752-869-8, pages 1 - 2.

### SUMMARY OF THE INVENTION

In a photonic-crystal surface-emitting laser (PCSEL), light oscillated due to two-dimensional in-plane resonance in a photonic crystal layer is diffracted in a direction perpendicular to the plane, and emitted light is extracted from a substrate side.

At that time, light diffracted from the photonic crystal layer toward the substrate side (direct diffracted light) and light diffracted in an opposite direction and reflected by a reflection surface (reflected diffracted light) interfere with each other. Due to this interference, characteristics such as the slope efficiency of the emitted light are greatly changed.

The interference between the direct diffracted light and the reflected diffracted light is determined by an optical path length of a semiconductor layer between the photonic crystal layer and the reflection surface, but it is very difficult to grow the semiconductor layer by controlling a layer thickness with high accuracy to such an extent that the optical path length can be determined. Therefore, it has been difficult to manufacture a photonic-crystal surface-emitting laser in which characteristics of emitted light are controlled with high accuracy.

The present invention has been made in view of the above points, and an object of the present invention is to provide a method of manufacturing a photonic-crystal surface-emitting laser in which an oscillation wavelength and emission light characteristics are controlled with high accuracy. Another object of the present invention is to provide a photonic-crystal surface-emitting laser having high-performance emission light characteristics such as high slope efficiency, and a method of manufacturing the photonic-crystal surface-emitting laser with good yield.

According to an embodiment of the present invention, there is provided a method of manufacturing a surface-emitting laser element, including:
(a) forming a first conductivity-type first semiconductor layer including a photonic crystal layer on a translucent substrate;
(b) performing crystal growth on the first semiconductor layer to form an active layer and a second conductivity-type second semiconductor layer in this order;
(c) performing spectrometry in which irradiation light is incident from a surface of the second semiconductor layer, and a layer thickness from the surface to a position where the irradiation light is reflected by the photonic crystal layer is measured;
(d) forming a translucent electrode, on the second semiconductor layer, having a layer thickness calculated on the basis of an optical path length corresponding to the layer thickness obtained through the spectrometry; and
(e) forming a light reflection layer on the translucent electrode, in which
the layer thickness of the translucent electrode is determined such that a light intensity of interference light of (i) direct diffracted light radiated from the photonic crystal layer and emitted from a back surface of the substrate and (ii) reflected diffracted light radiated from the photonic crystal layer and reflected by the light reflection layer is larger than a light intensity of the direct diffracted light.

### BRIEF DESCRIPTION OF THE DRAWINGS

FIG. 1A is a sectional view schematically showing an example of a structure of a photonic-crystal surface-emitting laser element 10 according to an embodiment of the present invention.
FIG. 1B is a partially enlarged sectional view schematically showing an air-hole layer 14P (photonic crystal layer) of FIG. 1A and air holes 14K arranged in the air-hole layer 14P.
FIG. 2A is a plan view schematically showing an upper surface of the PCSEL element 10 (a state in which a pad electrode 33 is removed).
FIG. 2B is a sectional view schematically showing a section of the air-hole layer 14P in a plane parallel to an n-side guide layer 14.
FIG. 2C is a plan view schematically showing a lower surface of the PCSEL element 10.
FIG. 3 is a diagram schematically showing an example of an air hole arrangement in a plane parallel to the photonic crystal layer 14P.
FIG. 4 is a manufacturing process flowchart showing a method of manufacturing the PCSEL element 10.
FIG. 5 is a diagram schematically showing an upper surface of a wafer WF after completion of crystal growth.
FIG. 6 is a graph showing a spectral reflection curve of the wafer WF after completion of the growth.
FIG. 7 is a diagram schematically showing surface reflected light ES and reflected light ER from the photonic crystal 14P when the wafer WF is irradiated with irradiation light EM of a spectral reflection measurement apparatus.
FIG. 8 is a diagram schematically showing interference between reflected diffracted light Lr that is reflected by a light reflection layer 32 and is emitted from a light emission surface and diffracted light Ld that is directly emitted from the light emission surface.
FIG. 9A is a graph plotting slope efficiency with respect to an oscillation wavelength of the PCSEL element 10 of Example (EX).
FIG. 9B is a graph plotting slope efficiency with respect to an oscillation wavelength of a PCSEL element of a comparative example CMP.

### DESCRIPTION OF THE PREFERRED EMBODIMENTS

Hereinafter, preferred embodiments of the present invention will be described, but these may be appropriately modified and combined. In the following description and the accompanying drawings, substantially the same or equivalent parts will be described with the same reference numerals.

### [First Embodiment]

### 1. Structure of photonic-crystal surface-emitting laser

### (a) Element structure

A photonic-crystal surface-emitting laser (hereinafter, also referred to as a PCSEL) has a resonator layer parallel to a semiconductor light emission structure layer (an n-side guide layer, a light emission layer. and a p-side guide layer) configuring a light emission element, and is an element that emits coherent light in a direction orthogonal to the resonator layer.

That is, in the photonic-crystal surface-emitting laser (PCSEL), a light wave propagating in a plane parallel to the photonic crystal layer is diffracted due to the diffraction effect of the photonic crystal to form a two-dimensional resonance mode, and is also diffracted in a direction perpendicular to the parallel plane. That is, in the photonic-crystal surface-emitting laser, a light extraction direction is a direction perpendicular to the resonance direction (in-plane parallel to the photonic crystal layer).

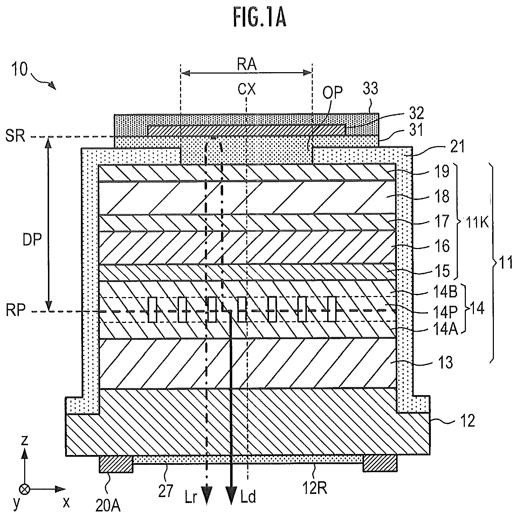

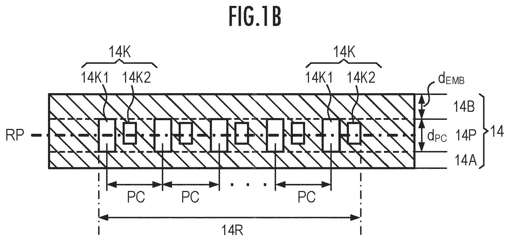

FIG. 1A is a sectional view schematically showing an example of a structure of a photonic-crystal surface-emitting laser element (hereinafter, referred to as a PCSEL element) 10 according to an embodiment of the present invention. FIG. 1B is an enlarged sectional view schematically showing a photonic crystal layer 14P in FIG. 1A and an air hole pair 14K arranged in the photonic crystal layer 14P.

As shown in FIG. 1A, a semiconductor structure layer 11 is formed on a translucent (i.e., light-transmissive) substrate 12. A semiconductor layer is laminated perpendicular to a central axis CX of the semiconductor structure layer 11.

The semiconductor structure layer 11 is made of a hexagonal nitride semiconductor. In the present embodiment, the semiconductor structure layer 11 is made of, for example, a GaN-based semiconductor.

More specifically, the semiconductor structure layer 11 including a plurality of semiconductor layers on the substrate 12, that is, an n-clad layer (first conductivity-type first clad layer) 13, and an n-side guide layer (first guide layer) 14 that is a guide layer provided on the n side, an active layer (ACT) 15, a p-side guide layer (second guide layer) 16 that is a guide layer provided on the p side, and an electron blocking layer (EBL) 17, a p-clad layer (second conductivity-type second clad layer) 18, and a p-contact layer 19 are formed in this order.

A case where the first conductivity type is an n type and the second conductivity type that is an opposite conductivity type of the first conductivity type is a p type will be described. However, the first conductivity type and the second conductivity type may be respectively a p type and an n type.

The substrate 12 is a hexagonal GaN single crystal and has a high transmittance of light emitted from the active layer 15. More specifically, the substrate 12 is a hexagonal GaN single crystal substrate having the +c plane of which a major surface (crystal growth plane) is the {0001} plane in which Ga atoms are arranged on the outermost surface. A back surface (light emission surface) is the -c plane that is the (000-1) face in which N atoms are arranged on the outermost surface. The -c face is resistant to oxidation and the like, and is thus suitable as a light emission surface.

The substrate 12 is not limited to this, but a so-called just substrate, or, for example, a substrate of which a major surface is offset to about 1° in the m-axis direction is preferably used. For example, a substrate of which a major surface is offset to about 1° in the m-axis direction can obtain mirror growth under a wide range of growth conditions.

A substrate surface (a back surface or a light emission surface) provided with a light emission region 20L opposite to the major surface is the "-c" plane that is the (000-1) plane in which N atoms are arranged on the outermost surface. The -c plane is resistant to oxidation and the like, and is thus suitable as a light extraction surface.

Hereinafter, configurations such as a composition and a layer thickness of each semiconductor layer will be described, but these are merely examples and can be appropriately modified and applied.

The n-clad layer 13 is, for example, an n-Al_{0.04}Ga_{0.96}N layer having an Al composition of 4% and a layer thickness of 2 µm. A composition ratio of aluminum (Al) is based on a composition in which a refractive index is smaller than that of a layer (that is, the n-side guide layer 14) adjacent to the active layer 15 side.

The n-side guide layer 14 includes a lower guide layer 14A, an air-hole layer 14P that is a photonic crystal layer (PC layer), and an embedded layer 14B. As shown in FIG. 1B, the air-hole layer 14P has a layer thickness d_{PC} and the embedded layer 14B has a layer thickness d_{EMB}.

The lower guide layer 14A is, for example, n-GaN having a layer thickness of 20 to 500 nm. The air-hole layer 14P is n-GaN having a layer thickness (or a height of the air hole 14K) d_{PC} of 60 to 150 nm.

The embedded layer 14B is made of n-GaN, n-InGaN, or undoped GaN or undoped InGaN. Alternatively, the embedded layer 14B may be a layer in which these semiconductor layers are laminated or stacked. The embedded layer 14B has a layer thickness of, for example, 50 to 150 nm.

The active layer 15 that is a light emission layer is, for example, a multiple quantum well (MQW) layer having two quantum well layers. The MQW barrier layer and quantum well layer are GaN (layer thickness of 6.0 nm) and InGaN (layer thickness of 3.0 nm), respectively. A gain wavelength of the active layer 15 is 432 nm.

The active layer 15 is preferably disposed within 180 nm from the air-hole layer 14P. In this case, a high resonance effect is obtained by the air-hole layer 14P.

The p-side guide layer 16 is made of, for example, undoped GaN or undoped InGaN and has a layer thickness of 100 to 350 nm. Although the p-side guide layer 16 is an undoped layer in consideration of light absorption of a dopant, magnesium (Mg) or the like may be doped in order to obtain good electrical conductivity.

Alternatively, the p-side guide layer 16 may have a structure in which an undoped layer and a doped layer are laminated. An InGaN layer and the GaN layer may be laminated as the p-side guide layer 16, and an In composition and a layer thickness of the InGaN layer may be selected as appropriate.

The electron blocking layer (EBL) 17 is a p-type Al_{0.2}Ga_{0.8}N layer doped with magnesium (Mg), and has a layer thickness of, for example, 15 nm.

The p-clad layer 18 is an Mg-doped p-Al_{0.06}Ga_{0.94}N layer, and has, for example, a layer thickness of 50 to 600 nm. An Al composition of the p-clad layer 18 is preferably selected such that a refractive index is smaller than that of the p-side guide layer 16.

The p-contact layer 19 is an Mg-doped p-GaN layer and has, for example, a layer thickness of 25 nm. A carrier density of the p-contact layer 19 is a concentration at which ohmic junction with the translucent (i.e., light-transmissive) electrode 31 provided on the surface of the p-contact layer 19 is possible. Instead of p-type GaN, p-type InGaN may be used. Alternatively, a layer in which a GaN layer and an InGaN layer are laminated may be used.

In the present specification, an "n side" and a "p side" do not necessarily mean having an n type and a p type. For example, the n-side guide layer means a guide layer provided on the n side of the active layer, and may be an undoped layer (or an i layer).

The n-clad layer 13 may include a plurality of layers instead of a single layer. In this case, all the layers need not be n layers (n-doped layers), and may include an undoped layer (i layer). The same applies to the guide layer 16 and the p-clad layer 18.

It is not necessary to provide all of the above semiconductor layers, and there may be a configuration in which a first conductivity-type first semiconductor layer including the photonic crystal layer, a second conductivity-type second semiconductor layer, and an active layer (light emission layer) interposed therebetween are provided.

The side surfaces and the upper surface of the semiconductor structure layer 11 are covered with an insulating film 21 such as SiO₂. The insulating film 21 is provided with an opening OP having a diameter RA (central axis CX) that exposes the upper surface of the semiconductor structure layer 11 (that is, the upper surface of the p-contact layer 19).

The insulating film 21 also functions as a protective film and protects the crystal layer containing aluminum (Al) forming the PCSEL element 10 from a corrosive gas and the like. The insulating film 21 prevents short circuits or the like due to deposits and creeping-up of a solder during mounting, and contributes to improvement of reliability and yield. A material of the insulating film 21 is not limited to SiO₂, and ZrO₂, HfO₂, TiO₂, Al₂O₃, SiNx, Si, and the like may be selected.

The translucent electrode 31 (anode) that makes ohmic contact with the p-contact layer 19 is provided on the p-contact layer 19 exposed from the opening OP. More specifically, the translucent electrode 31 fills the opening OP and is formed such that a peripheral edge portion straddles the insulating film 21. For better understanding, a region in the opening OP of the translucent electrode 31 will be described as an anode region RA by using the same reference numeral as the diameter of the opening OP.

The translucent electrode 31 is formed of a translucent conductor and is made of, for example, indium tin oxide (ITO). The translucent electrode 31 is not limited to ITO, and a translucent conductor such as zinc tin oxide (ZTO), GZO (ZnO:Ga), or AZO (ZnO:Al) may be used.

A silver alloy (Ag alloy) layer is provided as the light reflection layer 32 on the translucent electrode 31. The light reflection layer 32 is provided to cover at least the entire opening OP in a plan view. The light reflection layer 32 has a flat surface (upper surface) parallel to the air-hole layer 14P.

As the light reflection layer 32, Ag, Al, an Al alloy, a dielectric distributed Bragg reflector (DBR) or the like may also be used.

A pad electrode 33 made of nickel/palladium/gold (Ni/Pd/Au) is provided to cover the entire light reflection layer 32 on the light reflection layer 32. For the pad electrode 33, Ni/Au, platinum/gold (Pt/Au), Pt/Pd/Au, titanium/gold (Ti/Au), Ti/Pt/Au, tungsten/palladium/gold (W/Pd/Au), W/Au, W/Pt/Au, and the like may also be used.

An annular cathode electrode 20A is formed on the back surface of the substrate 12. A non-reflection (AR) coat layer 27 is formed inside the cathode electrode 20A.

The cathode electrode 20A is made of Ti/Pt/Au and is in ohmic contact with the substrate 12. In addition to Ti/Pt/Au, as electrode materials, Ti/Al, Ti/Rh, Ti/Al/Pt/Au, Ti/Au, vanadium/aluminum (V/Al), V/Rh, and V/Al/Pt./Au, V/Pt/Au, and the like may be selected.

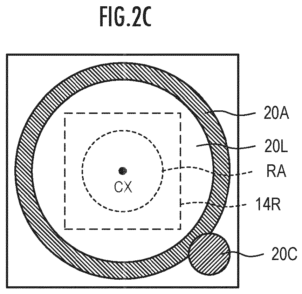

Radiated light from the active layer 15 is diffracted by the air-hole layer (PC layer) 14P. Light (direct diffracted light Ld: first diffracted light) diffracted by the air-hole layer 14P and directly emitted from the air-hole layer 14P, and light (reflected diffracted light Lr: second diffracted light) emitted due to diffraction of the air-hole layer 14P and reflected by the light reflection layer 32 are emitted to the outside from the light emission region 20L (FIG. 2C) of the back surface (emission surface) 12R of the substrate 12.

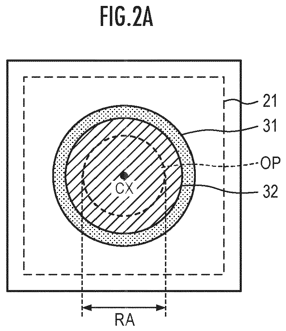

FIG. 2A is a plan view schematically showing the upper surface of the PCSEL element 10. FIG. 2A schematically shows the upper surface in a state in which the pad electrode 33 is removed for the sake of clarity in the figure and better understanding.

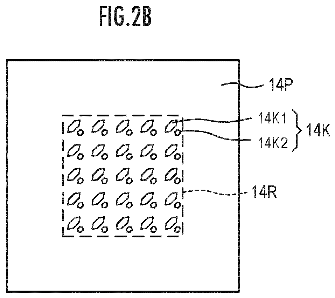

FIG. 2B is a sectional view schematically showing a section of the air-hole layer 14P in a plane parallel to the n-side guide layer 14, and FIG. 2C is a plan view schematically showing a lower surface of the PCSEL element 10.

As shown in FIG. 2B, in the air-hole layer 14P, the air holes 14K are periodically arranged and provided in, for example, a rectangular air hole forming region 14R. As shown in FIG. 2C, the anode region RA is formed to be included in the air hole forming region 14R.

The cathode electrode 20A is provided as an annular electrode on the outside of the air hole forming region 14R not to overlap the air hole forming region 14R when viewed from a direction perpendicular to the air-hole layer 14P.

A region inside the cathode electrode 20A is the light emission region 20L. A bonding pad 20C that is electrically connected to the cathode electrode 20 and is connected to a wire for supplying power from the outside is provided.

### (b) Photonic crystal layer

As shown in FIGS. 1A and 1B, the photonic crystal layer 14P includes regularly arranged air holes that resontate, in a horizontal plane, light radiated from the active layer 15.

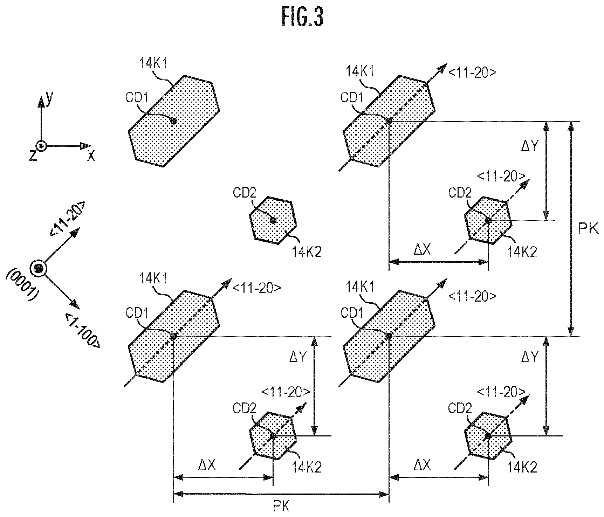

FIG. 3 is a diagram schematically showing an example of an air hole arrangement in a plane parallel to the photonic crystal layer 14P. That is, FIG. 3 is a plan view schematically showing a case where the air hole pair 14K (hereinafter, simply referred to as the air holes 14K in some cases) including a main air hole 14K1 and a secondary air hole 14K2 arranged at a square lattice position in the plane of the photonic crystal layer 14P is viewed from the upper surface.

That is, the photonic crystal layer 14P has a double-lattice structure. For the sake of clarity in the figure, the main air holes 14K1 and the secondary air holes 14K2 are hatched.

More specifically, the main air holes 14K1 are arranged at square lattice positions with a period PK in two directions (x-direction and y-direction) in which centroids CD1 are orthogonal to each other. Similarly, the secondary air holes 14K2 are arranged at square lattice positions with the period PK in the x-direction and the y-direction.

The main air hole 14K1 has a long hexagonal shape surrounded by the m-plane that is the {10-10} plane in a plan view (that is, when viewed from a direction perpendicular to the photonic crystal layer 14P). The secondary air hole 14K2 also has a shape surrounded by the m-plane.

The x-direction and the y-direction are directions inclined by 45° with respect to the major axis direction (<11-20> direction) and the minor axis direction (<1-100> direction) of the main air hole 14K1, respectively. In the present specification, the x-y coordinate is also referred to as an air hole coordinate.

The centroid CD2 of the secondary air hole 14K2 is separated from the centroid CD1 of the main air hole 14K1 by Δx in the x direction and Δy in the y direction. Here, Δx = Δy = 0.46PK is set. That is, the centroid CD2 of the secondary air hole 14K2 is separated from the centroid CD1 of the main air hole 14K1 in the <1-100> direction.

Here, the distance Δx between the centroids in the x direction and the distance Δy between the centroids in the y direction may be adjusted as appropriate according to laser characteristics such as a current value required for a device to which the laser element is applied and a slope efficiency of the emission intensity of the laser.

Here, a case where the photonic crystal layer 14P has a double-lattice structure will be described as an example, but the present invention is not limited thereto. The photonic crystal layer 14P may have a single-lattice structure or a multi-lattice structure.

### 2. Method of manufacturing PCSEL element

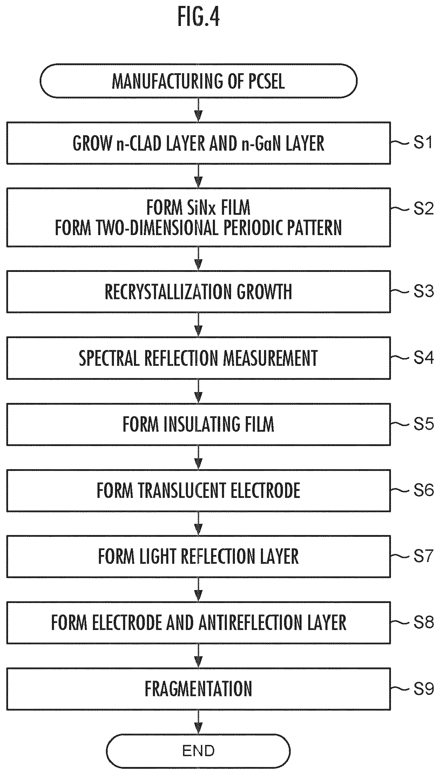

Next, a method of manufacturing the PCSEL element 10 will be described according to a manufacturing process flow shown in FIG. 4. In the following Example (EX), it was examined to improve the slope efficiency of the PCSEL element 10 having an oscillation wavelength of 432 nm.

### (S1: Crystal growth step)

A metalorganic vapor phase epitaxy (MOVPE) apparatus was used to form an n-Al_{0.04}Ga_{0.96}N layer that is the n-clad layer 13 with a thickness of 2 µm on the +c- plane GaN substrate 12. Subsequently, an n-GaN layer was subsequently formed with a thickness of 500 nm on the n-clad layer 13.

(S2: Patterning step) A SiNx film was formed on the n-GaN layer at about 100 nm by using a plasma CVD method. Next, an electron beam drawing resist was applied onto the SiNx film according to a spin coating method and placed in an electron drawing apparatus (EB apparatus) to form a two-dimensional periodic pattern corresponding to the above-described two-dimensional photonic crystal structure.

In this case, in order to examine the influence of a phase, the resist was patterned to have different air hole periods PKj in a plurality of air hole forming regions Wj such that an element having an oscillation wavelength of 429 nm to 440 nm can be obtained in the same substrate.

After the patterned resist was developed, SiNx was selectively dry-etched by using an inductively coupled plasma reactive ion etching (ICP-RIE) apparatus. As a result, the air holes arranged in a square lattice were formed to penetrate through the SiNx film.

Thereafter, the resist was removed, and the n-GaN layer was dry-etched by the ICP-RIE apparatus using Cl₂, BCl₃, and Ar gas with SiNx as a hard mask. An etching depth at this time was approximately 190 nm. Thereafter, the SiNx hard mask was removed with a buffered hydrofluoric acid (BHF).

### (S3: Recrystallization growth step)

The substrate on which the photonic crystal was formed was put into the MOVPE apparatus again and embedded and grown to leave air holes. That is, undoped GaN was grown to a thickness of 70 nm and undoped InGaN was grown to a thickness of 50 nm to form the embedded layer 14B. As a result, the n-side guide layer 14 including the photonic crystal layer 14P was formed.

Subsequently, two pairs of InGaN/GaN active layers 15 (MQW layers) were grown on the embedded layer 14B (that is, on the n-side guide layer 14). Subsequently, the p-side guide layer 16 was formed on the active layer 15 by growing undoped InGaN to a thickness of 70 nm and undoped GaN to a thickness of 180 nm.

Subsequently, the p-AlGaN electron blocking layer 17 was grown to a thickness of 15 nm, and the p-AlGaN layer (p-clad layer 18) was grown on the electron blocking layer 17 to a thickness of 300 nm. Next, the p-contact layer 19 made of a p-GaN/p-InGaN layer was grown to a thickness of 25 nm.

All the semiconductor layers formed on the n-side guide layer 14 will be referred to as semiconductor layers 11K on the guide layer.

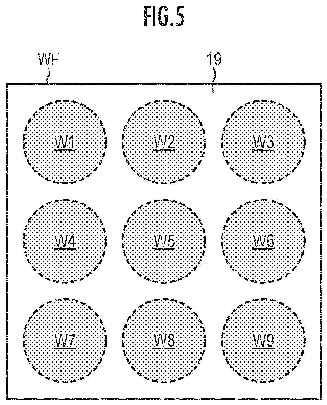

FIG. 5 is a diagram schematically showing an upper surface of the wafer WF formed as described above after completion of crystal growth. Specifically, FIG. 5 shows that the regions Wj (W1 to W9) in which air holes are arranged at different air hole periods PKj (where j = 1 to 9) are provided in the photonic crystal layer 14P formed in the n-side guide layer 14.

More specifically, the air hole period PKj in each of the regions W1 to W9 is set to be an integer multiple of an oscillation wavelength (λ). In order to set the oscillation wavelength to 429 nm to 440 nm, the air hole period PKj is set every 1.2 nm for PK1 = 172 nm, PK2 = 173.2 nm, ..., and PK9 = 182.8 nm.

The air holes 14K1 and 14K2 have a hexagonal shape surrounded by the m-plane that is the {10-10} plane in a plan view. A height of the main air hole 14K1 of the photonic crystal layer 14P was 90 nm, and a height of the secondary air hole 14K2 was 70 nm.

Here, the wafer WF having the different air hole period PKj for each region Wj is formed in order to perform evaluation using spectral reflection measurement that will be described later, but the photonic crystal layer 14P in one air hole period PK may be formed in the wafer WF for actually manufacturing the PCSEL element 10.

### (S4: Spectral reflection measurement step)

Light was incident from the outermost growth surface (that is, the surface of the p-contact layer 19) of the above-described grown wafer WF (hereinafter, also simply referred to as a wafer WF), and spectral reflection measurement was performed. A thickness of the translucent electrode 31 (translucent conductor film) to be subsequently formed was determined on the basis of results of the spectral reflection measurement. Details of a spectral reflection measurement method and results thereof will be described later.

### (S5: Insulating film forming step)

SiO₂ was formed with a thickness of 100 nm on the grown wafer WF through sputtering to form the insulating film 21. Subsequently, after patterning the resist according to photolithography, SiO₂ was removed by BFH to form an opening OP having a diameter of 300 um to which the upper surface of the p-contact layer 19 was exposed.

### (S6: Translucent electrode forming step)

Next, the translucent electrode 31 that is an ITO film covering the upper surface of the insulating film 21 and filling the inside of the opening OP was formed through sputtering.

Subsequently, the resist was patterned according to photolithography and then wet etching was performed to remove an ITO film in an unnecessary region to form the translucent electrode 31 having a flat surface and parallel to the photonic crystal layer 14P.

From the results of the spectral reflection measurement, a layer thickness of the translucent electrode 31 was set to 135 nm in the wafer WF of Example (EX). The wafer of the comparative example (CMP) was set to 135 nm that is the same as that of the wafer of Example (EX) in order to evaluate element characteristics.

That is, in Example (EX), the layer thickness of the translucent electrode 31 was set to a layer thickness at which conditions in which the phases of the direct diffracted light Ld and the reflected diffracted light Lr match and the two pieces of diffracted light are most intensified due to interference are satisfied, and, in the comparative example (CMP), the layer thickness was set to a layer thickness that deviates from the conditions in which the two pieces of diffracted light are most intensified (however, the light intensity is larger than that of the direct diffracted light Ld).

Here, conditions (interference conditions) in which a light intensity of interference light of the direct diffracted light Ld and the reflected diffracted light Lr is intensified may be conditions in which the light intensity of the interference light is larger than the light intensity of the direct diffracted light Ld. Conditions in which the phases of the direct diffracted light Ld and the reflected diffracted light Lr emitted from the PCSEL element 10 match and the two pieces of diffracted light are most intensified are preferably employed.

The layer thickness of the translucent electrode 31 may be a layer thickness satisfying conditions in which the light intensity of the interference light of the direct diffracted light Ld and the reflected diffracted light Lr is weakened.

### (S7: Light reflection layer forming step)

A silver (Ag) alloy was formed with a thickness of 150 nm on the translucent electrode 31 to form the light reflection layer 32. Due to the formation of the light reflection layer 32, a light reflection surface SR was formed at an interface between the translucent electrode 31 and the light reflection layer 32.

### (S8: Electrode and antireflection layer forming step)

Ni/Pd/Au was sequentially formed with a thickness of 10 nm/200 nm/800 nm on the light reflection layer 32 to form the pad electrode 33.

Next, the back surface of the substrate was polished and then mirror-finished through chemical mechanical polishing (CMP) to obtain the wafer WF having a thickness of 170 nm. Subsequently, Ti/Pt/Au (layer thickness: 50 nm/50 nm/500 nm) was formed on the polished surface to form the cathode electrode 20A.

SiNₓ/SiO₂ (layer thickness: 32 nm/53 nm) is formed on the back surface of the substrate in the inner region (that is, the light emission region 20L) of the cathode electrode 20A, and the non-reflection coat layer 27 that is an antireflection layer is formed.

### (S9: Dicing step)

Finally, the wafer WF was scribed by using a laser scribing device or a diamond scribing device, and was fragmented by using a cleaving device to obtain 80 PCSEL elements 10 having different air hole periods PK (oscillation wavelength λ).

### 3. Spectral reflection measurement and evaluation results

A spectral reflection measurement method in the above spectral reflection measurement step (S4) and results thereof will be described.

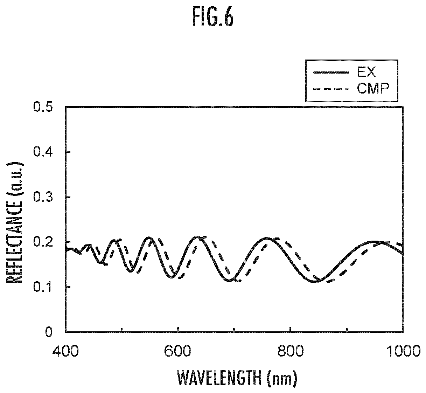

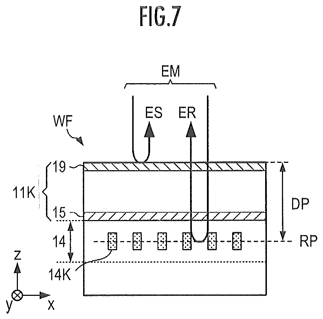

FIG. 6 is a graph showing a spectral reflection curve of the wafer WF after completion of growth. FIG. 7 is a diagram schematically showing surface reflected light ES and reflected light ER from the photonic crystal 14P when the wafer WF is irradiated with irradiattion light EM of a spectral reflection measurement apparatus. For the sake of clarity in the drawing, the main air holes 14K1 and the secondary air holes 14K2 of the photonic crystal layer 14P are shown as the air hole pair 14K.

The photonic crystal layer 14P is a layer including air holes and has a refractive index lower than that of other semiconductor layers. Thus, an observed spectral reflection curve shown in FIG. 6 is a result of interference between the surface reflected light ES and the reflected light ER from the photonic crystal 14P, as schematically shown in FIG. 7.

Since the back surface of the GaN substrate 11 is a rough surface, light is scattered and reflection on the back surface can be almost ignored. Since a refractive index difference between other semiconductor layers (for example, between GaN/AlGaN layers) is about 10⁻¹ to 10⁻², reflection at these interfaces has almost no influence.

The layer thickness was obtained from the spectral reflection curve shown in FIG. 6 as GaN for each semiconductor layer of the semiconductor layers 11K on the guide layer. Specifically, although the semiconductor layers 11K on the guide layer include a layer having a mixed crystal composition (InAlGaN layer), an optical path length from the photonic crystal layer 14P to the surface of the p-contact layer 19 is important. Therefore, calculation and fitting were performed assuming that the semiconductor layers 11K on the guide layer were a single layer of the GaN layer, and a layer thickness thereof was obtained.

The layer thickness of each semiconductor layer of the semiconductor layers 11K on the guide layer may be obtained in detail with a spectroscopic ellipsometer. A method of obtaining layer thickness may be performed by using an existing technique based on fundamental Fresnel reflection.

As described above, a layer thickness DP (or an optical path length) from the surface of the p-contact layer 19 (that is, the surface of the wafer WF) to a reflection position RP of the irradiation light (i.e., spectrometry light) EM in the photonic crystal layer 14P was determined. As a result, the layer thickness DP in Example EX was 735 nm.

A wafer grown under the same conditions as the wafer WF of Example EX described above was formed as a wafer WC of the comparative example CMP. That is, the wafer WC of Comparative Example CMP has an n-guide layer 14 and a photonic crystal 14P having the same structure as the wafer WF of Example EX.

That is, from the viewpoint of reproducibility of the layer thickness in the crystal growth, a growth layer thickness (the layer thickness of the semiconductor layers 11K on the guide layer) is assumed to be different between the wafer WF of Example EX and the wafer WC of the comparative example CMP even in the case of crystal growth under the same conditions.

Actually, as shown in FIG. 6, it was found that the spectral reflection curve was slightly shifted to the long wavelength side compared with the wafer WF of Example EX. From the measured spectral reflection curve, the layer thickness DP of the wafer WC of the comparative example CMP was determined and found to be DP = 755 nm. Therefore, it was found that the layer thickness of the semiconductor layers 11K on the guide layer differs from the wafer WF of Example EX by about 3%.

### 4. Characteristics evaluation of PCSEL element

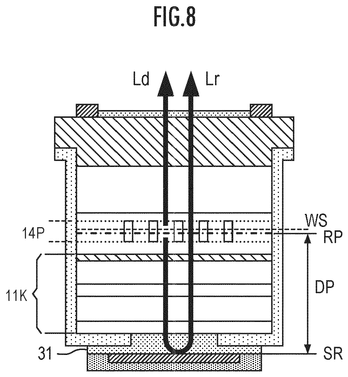

FIG. 8 schematically shows interference between the reflected diffracted light Lr that is radiated from the photonic crystal layer 14P, reflected by the light reflection layer 32 (light reflection surface SR), and emitted from the back surface (light emission surface) side of the substrate 12, and the direct diffracted light Ld emitted from the photonic crystal layer 14P toward the back surface side of the substrate 12.

The direct diffracted light Ld and the reflected diffracted light Lr interfere with each other due to an optical path length difference corresponding to the layer thickness DP. As is clear from FIG. 8, the optical path length difference between the direct diffracted light Ld and the reflected diffracted light Lr is the same as twice the distance that is a sum of the layer thickness DP and the layer thickness of the translucent electrode 31 (from the surface of the p-contact layer 19 to the light reflection layer 32). Thus, the layer thickness of the translucent electrode 31 satisfying the interference condition can be calculated by obtaining the layer thickness DP. In Example (EX), the layer thickness of the translucent electrode 31 is determined such that the phases of the direct diffracted light Ld and the reflected diffracted light Lr match. In the comparative example (CMP), the translucent electrode 31 having a layer thickness that deviates the conditions in which the phases of the direct diffracted light Ld and the reflected diffracted light Lr match is provided.

Since the spectral reflection measurement is used, the reflection position RP in the photonic crystal 14P can be directly measured. The measurement is non-destructive, and an optical path length can be calculated with high accuracy even in a layer in which a plurality of layers having different refractive indices are laminated. That is, the optical path length difference between the direct diffracted light Ld and the reflected diffracted light Lr can be measured directly and with high accuracy.

Specifically, the accuracy of the optical path length difference is within 1%, which is within 2 to 3 nm when converted into the layer thickness of the semiconductor layer.

A diffraction position (wave source position) WS of the diffracted light in the photonic crystal layer 14P may be slightly different from the reflection position RP in the spectrometry due to a difference between the oscillation wavelength and the wavelength of the irradiation light in the spectrometry (FIG. 8).

For example, from Non-Patent Literature 3, a wave source (diffraction surface) of the diffracted wave by the air-hole layer 14P and a radiated wave that is diffracted and radiated in the vertical direction of the air-hole layer 14P can be calculated by using the coupled wave theory.

However, in consideration of controllability and reproducibility of the layer thickness of the semiconductor layer in crystal growth, the diffraction position (wave source position) WS can be sufficiently approximated by the reflection position RP in the spectral reflection measurement.

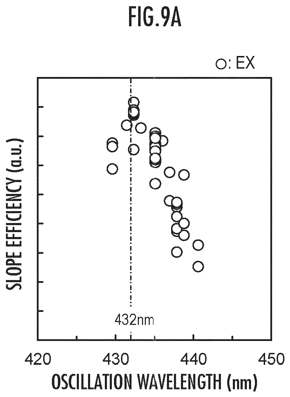

FIG. 9A is a graph plotting the slope efficiency with respect to the oscillation wavelength of the PCSEL element 10 of Example (EX) obtained from the wafer WF (the layer thickness of the translucent electrode 31: 135 nm).

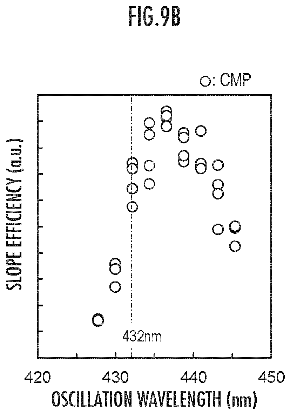

FIG. 9B is a graph plotting the slope efficiency with respect to the oscillation wavelength of the PCSEL element of the comparative example CMP obtained from the wafer WC (the layer thickness of the translucent electrode 31: 135 nm).

Specifically, results obtained by injecting a pulse current into the PCSEL element 10 of Example (EX) and the PCSEL element of the comparative example CMP, performing optical output measurement, and measuring the slope efficiency are shown.

As shown in FIG. 9A, in the PCSEL element 10 of Example (EX), the maximum slope efficiency was observed near an oscillation wavelength of 432 nm (one-dot chain line in the figure) that is a target oscillation wavelength. This is an effect due to interference, and when the oscillation wavelength changes, the optical path length changes and the slope efficiency changes.

On the other hand, as shown in FIG. 9B, in the PCSEL element of the comparative example CMP, the maximum slope efficiency was observed in the vicinity of 438 nm that is an oscillation wavelength deviating from the target oscillation wavelength. A width of the distribution of the slope efficiency is also larger than that of the PCSEL element 10 of Example (EX), and the yield of the element having a desired oscillation wavelength and the slope efficiency is low.

In other words, in the wafer WC of the comparative example CMP, in order to obtain the maximum slope efficiency at the oscillation wavelength of 432 nm as in the wafer WF of Example (EX), the layer thickness of the translucent electrode 31 may be 110 nm.

Even in a case where the photonic crystal layer 14P has a multi-lattice structure, the layer thickness DP (or optical path length) up to the reflection position RP can be actually measured with high accuracy. This is because, in the multi-lattice structure, the reflection position RP can change significantly depending on a relative size of the main air hole and the secondary air hole, a relative arrangement in the depth direction, and shapes.

The case where the crystal is grown according to the MOVPE method has been described, but the present invention is not limited thereto. For example, a gas phase growth method such as a molecular beam epitaxy (MBE) method, a hydride gas phase growth method (HVPE method), or a sputtering method, or a liquid phase growth method can also be applied.

As described above, spectral reflection measurement is performed on the wafer after crystal growth, the layer thickness of the semiconductor layer is analyzed, and the layer thickness of the translucent electrode 31 is determined according to the layer thickness. Consequently, it is possible to obtain a photonic-crystal surface-emitting laser in which the oscillation wavelength and the emission light characteristics are controlled with high accuracy, and to provide a method of manufacturing the photonic-crystal surface-emitting laser with high yield.

## Claims

1. A method of manufacturing a surface-emitting laser element (10), the method comprising:
(a) forming a first conductivity-type first semiconductor layer (14) including a photonic crystal layer (14P) on a translucent substrate (12);
(b) performing crystal growth on the first semiconductor layer (14) to form an active layer (15) and a second conductivity-type second semiconductor layer (16-19) in this order;
(c) performing spectrometry in which irradiation light is incident from a surface of the second semiconductor layer (16-19), and a layer thickness from the surface to a position where the irradiation light is reflected by the photonic crystal layer (14P) is measured;
(d) forming a translucent electrode (31), on the second semiconductor layer (16-19), having a layer thickness calculated on the basis of an optical path length corresponding to the layer thickness obtained through the spectrometry; and
(e) forming a light reflection layer (32) on the translucent electrode (31), wherein the layer thickness of the translucent electrode (31) is determined such that a light intensity of interference light of (i) direct diffracted light (Ld) radiated from the photonic crystal layer (14P) and emitted from a back surface (12R) of the substrate (12) and (ii) reflected diffracted light (Lr) radiated from the photonic crystal layer (14P) and reflected by the light reflection layer (32) is larger than a light intensity of the direct diffracted light (Ld).

2. The method of manufacturing a surface-emitting laser element (10) according to claim 1, wherein the spectrometry is performed by using a spectroscopic ellipsometer.

3. The method of manufacturing a surface-emitting laser element (10) according to claim 1, wherein the photonic crystal layer (14P) has a multi-lattice structure.

4. The method of manufacturing a surface-emitting laser element (10) according to claim 1, wherein the active layer (15) and the second semiconductor layer (16-19) are crystal-grown according to an MOVPE method.

5. The method of manufacturing a surface-emitting laser element (10) according to any one of claims 1 to 4, wherein the layer thickness of the translucent electrode (31) is determined such that phases of the direct diffracted light (Ld) and the reflected diffracted light (Lr) match each other.

## Patentansprüche

1. Verfahren zur Herstellung eines oberflächenemittierenden Laserelements (10), wobei das Verfahren Folgendes umfasst:
(a) Ausbilden einer ersten Halbleiterschicht (14) eines ersten Leitfähigkeitstyps, die eine photonische Kristallschicht (14P) umfasst, auf einem lichtdurchlässigen Substrat (12);
(b) Durchführen eines Kristallwachstums auf der ersten Halbleiterschicht (14), um in dieser Reihenfolge eine aktive Schicht (15) und eine zweite Halbleiterschicht (16-19) vom zweiten Leitfähigkeitstyp zu bilden;
(c) Durchführen einer Spektrometrie, bei der Bestrahlungslicht von einer Oberfläche der zweiten Halbleiterschicht (16-19) einfällt und eine Schichtdicke von der Oberfläche bis zu einer Position gemessen wird, an der das Bestrahlungslicht von der photonischen Kristallschicht (14P) reflektiert wird;
(d) Ausbilden einer lichtdurchlässigen Elektrode (31) auf der zweiten Halbleiterschicht (16-19) mit einer Schichtdicke, die auf der Grundlage einer optischen Weglänge berechnet wird, die der durch die Spektrometrie erhaltenen Schichtdicke entspricht; und
(e) Ausbilden einer Lichtreflexionsschicht (32) auf der lichtdurchlässigen Elektrode (31),
wobei die Schichtdicke der lichtdurchlässigen Elektrode (31) so bestimmt wird, dass eine Lichtintensität des Interferenzlichts aus (i) direktem gebeugtem Licht (Ld), das von der photonischen Kristallschicht (14P) ausgestrahlt und von einer Rückseite (12R) des Substrats (12) emittiert wird, und (ii) reflektiertem gebeugtem Licht (Lr), das von der photonischen Kristallschicht (14P) ausgestrahlt und von der Lichtreflexionsschicht (32) reflektiert wird, größer ist als die Lichtintensität des direkt gebeugten Lichts (Ld).

2. Verfahren zur Herstellung eines oberflächenemittierenden Laserelements (10) gemäß Anspruch 1, wobei die Spektrometrie unter Verwendung eines spektroskopischen Ellipsometers durchgeführt wird.

3. Verfahren zur Herstellung eines oberflächenemittierenden Laserelements (10) gemäß Anspruch 1, wobei die photonische Kristallschicht (14P) eine Mehrfachgitterstruktur aufweist.

4. Verfahren zur Herstellung eines oberflächenemittierenden Laserelements (10) gemäß Anspruch 1, wobei die aktive Schicht (15) und die zweite Halbleiterschicht (16-19) nach einem MOVPE-Verfahren kristallgezüchtet werden.

5. Verfahren zur Herstellung eines oberflächenemittierenden Laserelements (10) gemäß einem der Ansprüche 1 bis 4, wobei die Schichtdicke der lichtdurchlässigen Elektrode (31) so bestimmt wird, dass die Phasen des direkt gebeugten Lichts (Ld) und des reflektierten gebeugten Lichts (Lr) miteinander übereinstimmen.

## Revendications

1. Procédé de fabrication d'un élément laser à émission par la surface (10), le procédé comprenant :
(a) former une première couche semi-conductrice (14) d'un premier type de conductivité comprenant une couche de cristal photonique (14P) sur un substrat translucide (12) ;
(b) réaliser une croissance cristalline sur la première couche semi-conductrice (14) afin de former une couche active (15) et une deuxième couche semi-conductrice (16-19) d'un deuxième type de conductivité, dans cet ordre ;
(c) réaliser une spectrométrie dans laquelle une lumière d'irradiation est incidente depuis une surface de la deuxième couche semi-conductrice (16-19), et une épaisseur de couche depuis la surface jusqu'à une position où la lumière d'irradiation est réfléchie par la couche de cristal photonique (14P) est mesurée ;
(d) former une électrode translucide (31) sur la deuxième couche semi-conductrice (16-19), ayant une épaisseur de couche calculée sur la base d'une longueur de trajet optique correspondant à l'épaisseur de couche obtenue par la spectrométrie ; et
(e) former une couche réfléchissant la lumière (32) sur l'électrode translucide (31),
dans laquelle l'épaisseur de la couche de l'électrode translucide (31) est déterminée de telle sorte que l'intensité lumineuse de la lumière d'interférence de (i) la lumière diffractée directe (Ld) rayonnée à partir de la couche de cristal photonique (14P) et émise à partir d'une surface arrière (12R) du substrat (12) et (ii) la lumière diffractée réfléchie (Lr) rayonnée à partir de la couche de cristal photonique (14P) et réfléchie par la couche réfléchissant la lumière (32) est supérieure à l'intensité lumineuse de la lumière diffractée directe (Ld).

2. Procédé de fabrication d'un élément laser à émission par la surface (10) selon la revendication 1, dans lequel la spectrométrie est réalisée à l'aide d'un ellipsomètre spectroscopique.

3. Procédé de fabrication d'un élément laser à émission par la surface (10) selon la revendication 1, dans lequel la couche de cristal photonique (14P) a une structure à réseaux multiples.

4. Procédé de fabrication d'un élément laser à émission de surface (10) selon l' t la revendication 1, dans lequel la couche active (15) et la deuxième couche semi-conductrice (16-19) ont crû cristallines selon un procédé MOVPE.

5. Procédé de fabrication d'un élément laser à émission par la surface (10) selon l'une quelconque des revendications 1 à 4, dans lequel l'épaisseur de la couche de l'électrode translucide (31) est déterminée de telle sorte que les phases de la lumière diffractée directe (Ld) et de la lumière diffractée réfléchie (Lr) correspondent l'une à l'autre.
